# EUROPEAN PATENT APPLICATION

(11) **EP 4 560 338 A1**
(43) Date of publication of application: **28.05.2025**
(21) Application number: 24169691.3
(22) Date of filing: 11.04.2024
(51) Int. Cl.: G01R 31/396, G01R 31/54, G01R 31/66, H01M 10/42

(54) **BATTERY CONTACT FAILURE DETECTING DEVICE AND METHOD**

(30) Priority: 21.11.2023 KR 20230161871
(71) Applicant: Samsung SDI Co., Ltd., Yongin-si, Gyeonggi-do 17084 (KR)
(72) Inventor: Cho, Duck Gu, 16678 Suwon-si, Gyeonggi-do (KR)
(74) Representative: Gulde & Partner

(57) **Abstract**

A battery contact failure detecting device (200) according to the present invention includes a battery module (100, 210) formed of a plurality of battery cells (10, 10a, 10b); a connecting part (220) including at least one of a busbar, a contactor, and a fuse and connects the battery cells (10, 10a, 10b) to each other; a sensor (230) configured to measure a current and a voltage of each of the battery cells (10, 10a, 10b); and a processor (240) configured to count a number of abnormal occurrences on the basis of the current and the voltage measured by the sensor (230) to detect a contact failure of the battery cells (10, 10a, 10b) due to a short circuit or open circuit of the connecting part (220).

## Description

### BACKGROUND

### 1. Field

Aspects of embodiments of the present disclosure relate to a device and method capable of detecting a contact failure in a battery.

### 2. Description of the Related Art

A secondary battery is a battery that can be repeatedly charged and discharged, unlike a primary battery that cannot be recharged. Low-capacity secondary batteries are used in small portable electronic devices such as smartphones, feature phones, notebook computers, digital cameras, and camcorders, and high-capacity secondary batteries are widely used as driving power sources and power storage batteries for motors in hybrid and electric vehicles. Such a secondary battery includes an electrode assembly provided with a positive electrode and a negative electrode, a case for accommodating the electrode assembly, electrode terminals connected to the electrode assembly, and the like.

In the case of a high-voltage battery, a contact failure may occur among a busbar, a contactor, a fuse, and a cell. In the case of contact between the cell and the busbar, a voltage value is changed and recognized as an over voltage or an under voltage according to a current direction (charging or discharging), and thus a contact failure can be detected.

When a contact resistance is smaller than several mQ, there is a problem that a contact failure is not detected easily. In addition, when an instantaneous current flows, because a contact failure occurs for a time smaller than a mature time, there is a problem that the contact failure is not detected easily. When it is completely opened, there is no serious problem in detecting a contact failure, but in an initial stage, it is difficult to detect the contact failure.

Accordingly, a method of detecting a secondary failure (e.g., melting of contact portions due to high temperatures, or sudden output loss due to sudden opening of high voltage components such as busbars), which can occur due to a contact failure among a busbar, a contactor, a fuse, and a cell in a high-voltage battery in advance is required.

The information described above in the background technology of this invention is only to facilitate understanding of the background of the present invention and may also include information not included in the conventional technology.

### SUMMARY

The present invention is directed to providing a battery contact failure detecting device and a method that detect a secondary failure that can occur due to a contact failure among a busbar, a contactor, a fuse, and a cell in a high-voltage battery in advance to stably use the high-voltage battery.

However, technical objectives to be solved by the present invention are not limited to the above-described objective, and other objectives which are not described above will be clearly understood by those skilled in the art through the following description.

According to an aspect of the present invention, there is provided a battery contact failure detecting device including: a battery module formed of a plurality of battery cells; a connecting part which includes at least one of a busbar, a contactor, and a fuse and connects the battery cells to each other; a sensor which measures a current and a voltage of each of the battery cells; and a processor which counts a number of abnormal occurrences on the basis of the current and voltage measured by the sensor to detect a contact failure of the battery cells due to a short circuit or open circuit of the connecting part.

The processor may count the number of abnormal occurrences on the basis of the current measured by the sensor and a voltage difference between the battery cells.

In some embodiments, under a first condition in which the current measured by the sensor is greater than or equal to a specific threshold current, when a second condition that a voltage difference between the battery cells is greater than or equal to a preset reference value is satisfied, the processor may be configured to determine that an abnormality occurs and count the number of abnormal occurrences.

The processor may count the number of abnormal occurrences when the first condition and the second condition are satisfied for a reference time.

The processor may count the number of abnormal occurrences in units of times that are each preset to be smaller than a time for detecting an over voltage or an under voltage.

The processor may restrict use of the battery according to whether a contact failure of the battery cells is detected.

The processor may restrict use of the battery when the number of abnormal occurrences greater than or equal to a first set number is counted in succession.

The processor may restrict use of the battery when an accumulated number of abnormal occurrences greater than or equal to a second set number is counted.

According to another aspect of the present invention, there is provided a battery contact failure detecting method comprising: measuring, by a sensor, a current and a voltage of each of a plurality of battery cells; counting, by a processor, a number of abnormal occurrences on the basis of the current and voltage measured by the sensor; and detecting, by the processor, a contact failure of the battery cells due to a short circuit or open circuit of a connecting part which connects the battery cells to each other on the basis of the counted number of abnormal occurrences.

The counting of the number of abnormal occurrences may include counting the number of abnormal occurrences on the basis of the current measured by the sensor and a voltage difference between the battery cells.

In some embodiments, the counting of the number of abnormal occurrences may include determining whether a first condition that the current measured by the sensor is greater than or equal to a specific current is satisfied, determining whether a second condition that the voltage difference between the battery cells is greater than or equal to a preset reference value is satisfied, determining that an abnormality occurs when the first condition and the second condition are satisfied, and counting the number of abnormal occurrences.

The counting of the number of abnormal occurrences may include counting the number of abnormal occurrences when the first condition and the second condition are satisfied for a reference time.

The counting of the number of abnormal occurrences may include counting the number of abnormal occurrences in units of times that are each preset to be smaller than a time for detecting an over voltage or an under voltage.

The battery contact failure detecting method may further comprise restricting, by the processor, use of the battery according to whether the contact failure of the battery cells is detected.

The restricting of the use of the battery may include restricting the use of the battery when the number of abnormal occurrences greater than or equal to a first set number is counted in succession and/or when an accumulated number of abnormal occurrences greater than or equal to a second set number is counted.

All embodiments described in this specification may be advantageously combined with one another to the extent that their respective features are compatible. In particular, the expressions "according to an embodiment," "in an embodiment," "an embodiment of the invention provides" etc. mean that the respective features may or may not be part of specific embodiments of the present invention.

### BRIEF DESCRIPTION OF THE DRAWINGS

Because the accompanying drawings of the present specification illustrate exemplary embodiments and serve to convey the technical scope of the present invention with the detailed description of the present invention, the present invention should not be limited and interpreted by content in the accompanying drawings, in which:
FIG. 1 is a perspective view illustrating an example of a battery module according to an embodiment of the present invention;
FIG. 2 is a block diagram of a battery contact failure detecting device according to an embodiment of the present invention;
FIG. 3 is a signal diagram illustrating an example of a current waveform for counting the number of abnormal occurrences according to an embodiment of the present invention;
FIG. 4 is a signal diagram illustrating an example of a voltage difference waveform between cells for counting the number of abnormal occurrences according to an embodiment of the present invention; and
FIG. 5 is a flow diagram for describing a battery contact failure detecting method according to an embodiment of the present invention.

### DETAILED DESCRIPTION

Hereinafter, exemplary embodiments of the present invention will be described in detail with reference to the accompanying drawings. First, terms and words used in the present specification and claims should not be interpreted as being limited to commonly used meanings or meanings in dictionaries and should be interpreted as having meanings and concepts which are consistent with the technological scope of the present invention based on the principle that the inventors have appropriately defined concepts of the terms in order to describe the present invention in the best way. Therefore, because the embodiments described in this specification and components illustrated in the drawings are only some exemplary embodiments and do not represent the overall technological scope of the present invention, it should be understood that there may be various suitable equivalents or modifications substituting the exemplary embodiments at the time of filing of this application. In addition, the terms "comprise," "include," "comprising," and/or "including" used herein specify some stated shapes, numbers, steps, operations, members, elements, and/or presence of groups thereof but do not preclude one or more other shapes, numbers, operations, members, elements, and/or presence or addition of groups thereof. In addition, when the embodiments of the present invention are described, the terms "may" or "may be" may include "one or more embodiments of the present invention."

In addition, in order to facilitate understanding of the present invention, the accompanying drawings are not drawn to scale, and dimensions of some components may be exaggerated. In addition, like reference numerals may be assigned to like elements in different embodiments.

The expression "two comparative objects are the same" means "the two comparative objects are practically the same." Therefore, the term "practically the same" includes a case in which there is a deviation considered as a low level in the art, for example, a deviation of 5% or less. In addition, the description "some parameters are uniform within a certain region" may mean that "some parameters are uniform in an average viewpoint."

Although terms such as "first," "second," or the like may be used for describing various elements, the elements are not limited by the terms. These terms are only used to distinguish one element from another element, and unless otherwise specifically described, a first element may also be a second element.

Throughout the specification, unless specifically described otherwise, each element may be singular or provided as a plurality.

A case in which a first element is disposed "over (or under)" or "above (or below)" a second element may include a case in which the first element is disposed in contact with an upper (or lower) surface of the second element or a case in which a third element is interposed between the first element and the second element disposed over (or under) the first element.

When a first element is referred to as being "connected," "coupled," or "bonded" to a second element, although the first element may be directly connected or bonded to the second element, it should be understood that a third element may be interposed therebetween, or the elements may be connected, coupled, or bonded through other elements. In addition, when a first part is referred to as being "electrically connected" to a second part, it includes not only a case in which the first part is "directly connected" to the second part but also a case in which the first part is "connected" to the second part with a third element interposed therebetween.

Throughout the specification, unless otherwise specifically described, "A and/or B" means "A," "B," or "A and B." That is "and/or" includes all combinations or any combination of a plurality of listed items. Unless otherwise specifically described, "C to D" means "more than or equal to C and less than or equal to D."

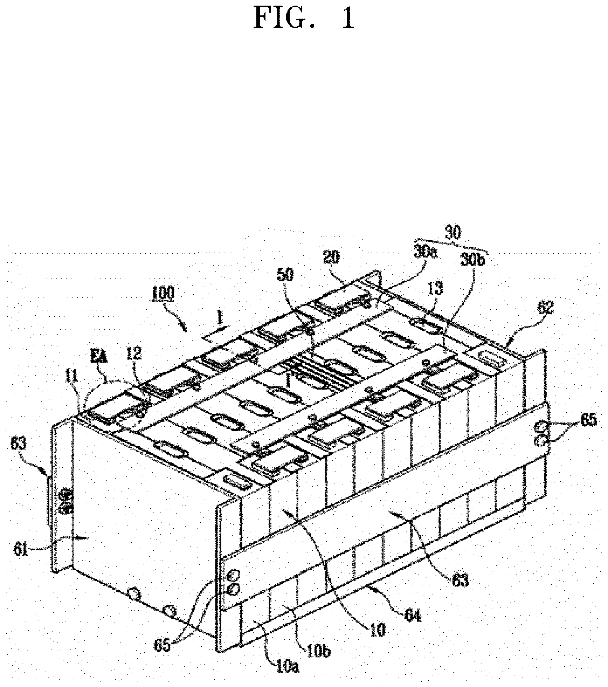

FIG. 1 is a perspective view illustrating an example of a battery module according to an embodiment of the present invention.

Referring to FIG. 1, a battery module 100 according to the present invention includes a plurality of battery cells 10 which include terminal parts 11 and 12 and are arrayed (e.g., stacked) in one direction, a connecting tab 20 that connects a battery cell 10a and an adjacent battery cell 10b, and a protection circuit module 30 of which one end portion is connected to the connecting tab 20. The protection circuit module 30 may be a battery management system (BMS). In addition, the connecting tab 20 may include a body portion 22 in contact with the terminal parts 11 and 12 between the battery cells 10a and 10b and an extension portion which extends from the body portion 22 and is connected to the protection circuit module 30. The connecting tab 20 may be a busbar.

First, the battery cell 10 may be formed with a battery case and an electrode assembly and an electrolyte, which are accommodated in the battery case. The electrode assembly and the electrolyte generate energy by electrochemically reacting to each other. The terminal parts 11 and 12 electrically connected to the connecting tab 20 and a vent 13 which is a discharge passage of gas generated therein may be provided on one side of the battery cell 10. The terminal parts 11 and 12 of the battery cell 10 may be a positive terminal 11 and a negative terminal 12 which have different polarities, and the terminal parts 11 and 12 of the adjacent battery cells 10a and 10b may be electrically connected in series or parallel by the connecting tab 20 which will be described further below. For example, although the serial connection has been illustrated and described above, the present invention is not limited to such a structure, and any of various suitable connection structures may be used as desired. In addition, the number and an array of the battery cells 10 are not limited to the structure illustrated in FIG. 1 and may be changed as desired.

A plurality of battery cells 10 may be arrayed (e.g., stacked) in one direction so that wide surfaces of the battery cells 10 face each other, and the arrayed plurality of battery cells 10 may be fixed by housings 61, 62, 63, and 64. The housings 61, 62, 63, and 64 may include a pair of end plates 61 and 62 facing the wide surfaces of the battery cells 10 and side plates 63 and a bottom plate 64 which connect the pair of end plates 61 and 62. The side plates 63 may support side surfaces of the battery cells 10, and the bottom plate 64 may support bottom surfaces of the battery cells 10. In addition, the pair of end plates 61 and 62 and the side plates 63 and the bottom plate 64 may be connected by members such as bolts 65.

The protection circuit module 30, on which electric components, protection circuits, and the like are mounted, may be electrically connected to the connecting tab 20 which will be described further below. The protection circuit module 30 may include a first protection circuit module 30a and a second protection circuit module 30b which extend at different locations in a direction in which the plurality of battery cells 10 are arrayed (e.g., stacked). In this case, the first protection circuit module 30a and the second protection circuit module 30b may be spaced at a set or predetermined distance to be located in parallel and connected to the adjacent connecting tab 20. For example, the first protection circuit module 30a may be formed on one upper side of the plurality of battery cells 10 to extend in the direction in which the plurality of battery cells 10 are arrayed (e.g., stacked), and the second protection circuit modules 30b may be formed on the other upper side of the plurality of battery cells 10 to extend in the direction in which the plurality of battery cells 10 are arrayed (e.g., stacked). In addition, the second protection circuit module 30b may be located to be spaced the set or predetermined distance from the first protection circuit module 30a with the vent 13 interposed therebetween and disposed parallel to the first protection circuit module 30a.

As described above, because two protection circuit modules are disposed to be spaced apart from each other to be parallel to the direction in which the plurality of battery cells are arrayed (e.g., stacked), an area of a printed circuit board (PCB) constituting the protection circuit modules is reduced (e.g., minimized). Because the protection circuit modules are separately formed, unnecessary area of the PCB is reduced (e.g., minimized). In addition, the first protection circuit module 30a and the second protection circuit module 30b may be connected to each other by a conductive connecting member 50. In this case, one side of the connecting member 50 may be connected to the first protection circuit module 30a, the other side thereof may be connected to the second protection circuit module 30b, and thus electric connection between the two protection circuit modules may be completed. The connection may be performed by any one method of soldering, resistance welding, laser welding, and projection welding methods, or the like.

In addition, as one example, the connecting member 50 may be an electric wire. In addition, the connecting member 50 may be formed of an elastic or flexible material. Whether voltages, temperatures, and currents of the plurality of battery cells 10 are normal may be checked and managed through the connecting member 50. That is, information of voltages, currents, temperatures, and the like transmitted to the first protection circuit module from adjacent connecting tabs and information of voltages, currents, temperatures, and the like transmitted to the second protection circuit module from adjacent connecting tabs may be integrally managed by the protection circuit module through the connecting member.

In addition, when the battery cell 10 is swelled, an impact is absorbed by the elasticity or flexibility of the connecting member 50, and thus damage to the first and second protection circuit modules 30a and 30b can be prevented or substantially reduced.

In addition, a shape and a structure of the connecting member 50 are not limited to those illustrated in FIG. 1, and the connecting members 50 may have any suitable shape or structure.

As described above, because the protection circuit module 30 is provided with the first and the second protection circuit modules 30a and 30b, the area of the PCB constituting the protection circuit module can be reduced (e.g., minimized), and thus space in the battery module can be secured. Accordingly, fastening work of connecting the connecting tab 20 and the protection circuit module 30 and repairing work when an abnormality of the battery module is detected are easily performed to improve (e.g., increase) operation efficiency.

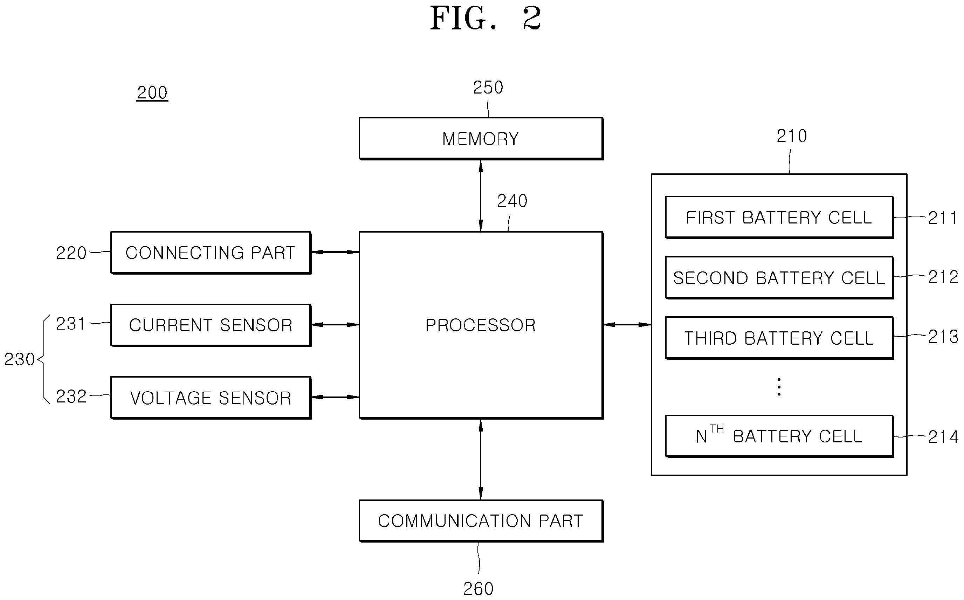

FIG. 2 is a block diagram of a battery contact failure detecting device according to an embodiment of the present invention.

Referring to FIG. 2, a battery contact failure detecting device 200 according to one embodiment of the present invention may include a battery module 210, a connecting part 220, a sensor 230, a processor 240, a memory 250, and a communication part 260.

The battery module 210 may include a plurality of battery cells, that is, a first battery cell 211 to an n^{th} battery cell 214. The plurality of battery cells 211 to 214 may be connected in series or parallel.

The connecting part 220 may include at least one of a busbar, a contactor, and a fuse. The connecting part 220 may serve to connect the battery cells 211 to 214.

For example, when an abnormality occurs in an apparatus or device connected to the battery module 210 or the battery contact failure detecting device 200, the contactor may block an output of the battery module 210 or power supplied to the battery module 210 from the outside.

The contactor may be selectively turned on or off according to a control command of the processor 240. To this end, the contactor may be implemented as a relay such as a mechanical contactor which is selectively turned on/off by a magnetic force of a coil. In some examples, the contactor may be implemented as a semiconductor switch such as a metal-oxide-semiconductor field-effect transistor (MOSFET).

The sensor 230 may measure a current and a voltage of each of the battery cells 211 to 214. To this end, the sensor 230 may include a current sensor 231 and a voltage sensor 232.

The current sensor 231 may measure a current of the battery module 210. The current sensor 231 may include a plurality of current sensors 231 to measure the current of each of the battery cells 211 to 214.

In this case, the current sensor 231 may be connected to at least one of an input terminal and an output terminal of each of the battery cells 211 to 214 to measure the current.

The voltage sensor 232 may measure a voltage of the battery module 210. The voltage sensor 232 may include a plurality of voltage sensors 232 to measure the voltage of each of the battery cells 211 to 214.

In this case, the voltage sensor 232 may be connected to at least one of the input terminal and the output terminal of each of the battery cells 211 to 214 to measure the voltage.

The processor 240 may monitor a state of each of the plurality of battery cells 211 to 214, determine a state of charge (SOC), and calculate a state of health (SOH). The processor 240 may detect a failure of the battery module 210 and the plurality of battery cells 211 to 214.

The processor 240 may control charging and discharging of the plurality of battery cells 211 to 214, control temperatures of the battery cells 211 to 214, and perform balancing control. In addition, the processor 240 may perform at least one protection function among over-discharge prevention, over-charge prevention, over-current prevention, short circuit prevention, and fire extinguishing functions on the basis of a state monitoring result.

The processor 240 may include any one of a battery management system (BMS), a battery pack control module (BPCM), a central processing unit (CPU), an electronic control unit (ECU), and a micro controller unit (MCU).

The processor 240 may count the number of abnormal occurrences on the basis of a current measured by the current sensor 231 and a voltage measured by the voltage sensor 232.

That is, the processor 240 may count the number of abnormal occurrences on the basis of the current measured by the sensor 230, and a voltage difference between the battery cells 211 to 214.

For example, under a first condition in which a current measured by the sensor 230 is greater than or equal to a threshold current, when a second condition that a voltage difference between the battery cells 211 to 214 is greater than or equal to a reference value (e.g., a preset reference value) is satisfied, the processor 240 may determine that an abnormality occurs and count the number of abnormal occurrences.

In this case, when a current measured by the sensor 230 is greater than any one of values in the range of 80 A to 120 A, the processor 240 may determine that the first condition is satisfied. In some embodiments, when a current measured by the sensor 230 is greater than 100 A, the processor 240 may determine that the first condition is satisfied.

In addition, when a voltage difference between the battery cells 211 to 214 is greater than any one of values in the range of 550 mV to 650 mV, the processor 240 may determine that the second condition is satisfied. In some embodiments, when a voltage difference between the battery cells 211 to 214 is greater than 600 mV, the processor 240 may determine that the second condition is satisfied.

In this case, when the first condition and the second condition are satisfied for a reference period of time (e.g., 100 ms or more), the processor 240 may count the number of abnormal occurrences. In this case, a process of counting the number of abnormal occurrences may be performed in units of preset times, wherein, for example, each of the preset times may be smaller than a time for detecting an over voltage or an under voltage condition, that is, the process may be performed for a set or predetermined time in the range of, for example, 200 ms to 300 ms.

The processor 240 may detect a contact failure of each of the battery cells 211 to 214 due to a short circuit or open circuit of the connecting part 220 on the basis of the counted number of abnormal occurrences.

The processor 240 may restrict use of the battery according to whether the contact failure of each of the battery cells 211 to 214 occurs.

For example, when the number of abnormal occurrences greater than or equal to a first set number is counted in succession, the processor 240 may restrict use of the battery. In addition, when the accumulated number of abnormal occurrences (which may include even non-successive abnormal occurrences) greater than or equal to a second set number is counted, the processor 240 may restrict use of the battery.

The memory 250 may store current data and voltage data input from the sensor 230, set data for processing the current data or voltage data, data about the battery module 210, reference data for determining a state of the battery module 210, SOC data of the battery module 210 or the battery cells 211 to 214, data generated during an operation process of the processor 240, and/or the like.

The memory 250 may store data for detecting damage to the battery cells 211 to 214 on the basis of the current data and the voltage data, for example, level data, weight data, cumulated weight data, specified range data, cell damage range data, and/or the like.

The memory 250 may include data about at least one of a data processing algorithm, a data level determination algorithm, a weight setting algorithm, a damage prediction algorithm, a contactor control algorithm, and a battery diagnosis algorithm.

The memory 250 may include a storage medium such as a random-access memory (RAM) and a non-volatile memory such as a read-only memory (ROM), an electrically erased programmable ROM (EEPROM), a flash memory, and/or the like.

The communication part 260 may transmit and receive data to and from the battery module 210, the connecting part 220, the sensor 230, the processor 240, and the memory 250. In addition, the communication part 260 may transmit and receive data to and from main a processor (not shown) of an apparatus or device including the processor 240 and the battery contact failure detecting device 200.

For example, the communication part 260 may include a controller area network (CAN) or local interconnect network (LIN) communication driver to transmit and receive data. The communication part 260 may transmit and receive data through serial or parallel communication.

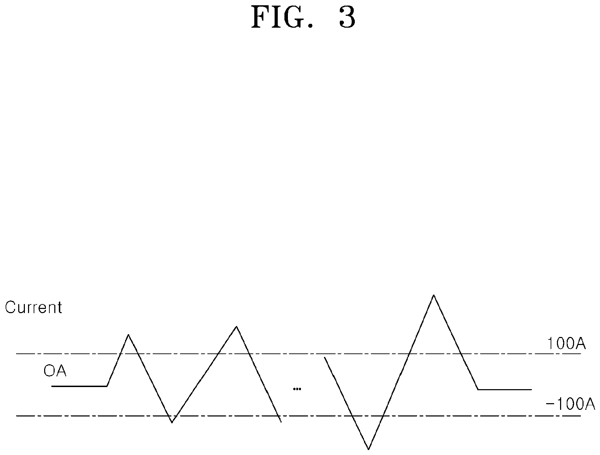

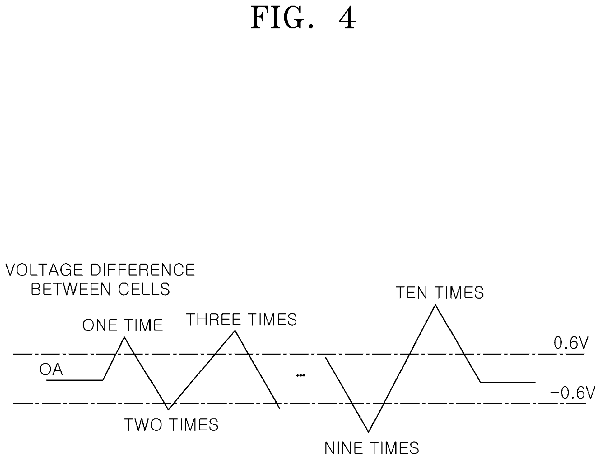

FIG. 3 is a signal diagram illustrating an example of a current waveform for counting the number of abnormal occurrences according to some embodiments of the present invention. FIG. 4 is a signal diagram illustrating an example of a voltage difference waveform between the cells for counting the number of abnormal occurrences according to an embodiment of the present invention.

Referring to FIGS. 2, 3, and 4, when the first condition that a current measured by the sensor 230 is greater than 100 A is satisfied and the second condition that a voltage difference between the battery cells 211 to 214 is greater than 600 mV is satisfied, the processor 240 may determine that an abnormality occurs in the battery cells 211 to 214 and count the number of abnormal occurrences.

In this case, for example, when the first condition and the second condition are satisfied for 100 ms, the processor 240 may count the number of abnormal occurrences. In addition, the processor 240 may perform a process of counting the number of abnormal occurrences in units of preset times for a time in the range of 200 to 300 ms which is smaller than a mature time (e.g., three seconds) which is a time for detecting an over voltage or an under voltage.

As illustrated in FIGS. 3 and 4, when ten abnormalities are counted in succession, that is, problems continuously occur, the processor 240 may recognize the sequential abnormalities as a problem situation and restrict use of the battery to stably manage the battery. In addition, the processor 240 may restrict use of the battery even when the accumulated number of abnormal occurrences (which may include even non-successive abnormal occurrences) is greater than or equal to 100.

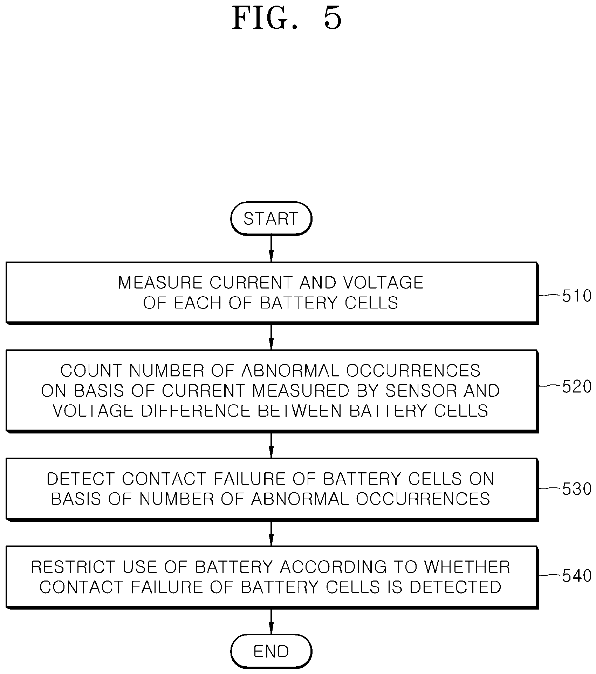

FIG. 5 is a flow diagram for describing a battery contact failure detecting method according to an embodiment of the present invention.

The battery contact failure detecting method which will be described further below is representative of only an embodiment of the present invention. For example, various suitable operations may be added in addition thereto as described further below, the following operations may be performed in a different order, and thus the present disclosure is not limited to the operations and order which will be described further below.

Referring to FIGS. 2 and 5, in operation 510, the sensor 230 may measure a current and a voltage of each of the battery cells 211 to 214.

Then, in operation 520, the processor 240 may count the number of abnormal occurrences on the basis of the current measured by the sensor 230 and a voltage difference between the battery cells 211 to 214.

Then, in operation 530, a contact failure of each of the battery cells 211 to 214 due to a short circuit or open circuit of the connecting part 220 may be detected on the basis of the counted number of abnormal occurrences.

Then, in operation 540, the processor 240 may restrict use of the battery according to whether the contact failure of each of the battery cells 211 to 214 occurs.

According to some embodiments of the present invention, a voltage which becomes different from an actual voltage due to a contact resistance when the contact resistance increases and a high current flows is used as a method of detecting a secondary failure (such as melting of contact portions due to high temperatures, or sudden output loss due to sudden opening of high voltage components such as busbars) which can occur due to a contact failure among a busbar, a contactor, a fuse, and a cell in a high-voltage battery in advance, and thus a battery contact failure can be efficiently detected.

According to some embodiments of the present invention, because a phenomenon in which a voltage difference occurs whenever a high current flows is used to count the number of times in units of several hundreds of ms (e.g., 200 ms to 300 ms) much smaller than the conventional mature time (e.g., 3 seconds), a battery contact failure problem due to an open circuit of a connecting part such as a busbar, a contactor, or a fuse can be recognized even within a short time, and when the number of abnormal occurrences greater than or equal to a set number is counted, it can be detected as a problem.

According to the present invention, when a battery contact failure is detected, use of a high-voltage battery can be restricted to stably use the high-voltage battery.

However, effects which can be achieved through the present invention are not limited to the above-described effects, and other effects which are not described above will be clearly understood by those skilled in the art from the above description of the present invention.

Although the present invention has been described above with reference to some embodiments and drawings, the present invention is not limited thereto, and various suitable modifications and changes may be made by those skilled in the art in the technical scope of the present invention and equivalents of the scope which will be described in the appended claims.

The present invention described in this specification can be implemented through, for example, a method, a process, an apparatus, a software program, a data stream, or a signal. Even when the present invention is described as being implemented in only a single form (for example, as the method), the described features may be implemented in another form (for example, as the apparatus or program). The apparatus may be implemented using proper hardware, software, firmware, or the like. For example, the method may be implemented in an apparatus such as a processor which is generally a processing device such as a computer, a microprocessor, an integrated circuit, or a programmable logic device. The processor includes a communication device such as a computer, a cell phone, a portable/personal digital assistant (PDA) terminal, and other devices which facilitate information communication between final users.

In this case, the processor may be implemented as a CPU or system on chip (SoC), may drive an operating system or application to control a plurality of hardware or software components connected to the processor, and may perform various suitable types of data processing and operations. The processor may be configured to execute at least one command stored in the memory and store result data of the execution in the memory.

While the present invention has been described with reference to embodiments illustrated in the accompanying drawings, these are merely exemplary. It will be understood by those skilled in the art that various suitable modifications and other equivalent example embodiments may be made from the embodiments of the present invention. Therefore, the scope of the present invention is defined by the appended claims.

## Claims

1. A battery contact failure detecting device (200) comprising:
a battery module (100, 210) formed of a plurality of battery cells (10, 10a, 10b);
a connecting part (220) comprising at least one of a busbar, a contactor, and a fuse and connects the battery cells (10, 10a, 10b) to each other;
a sensor (230) configured to measure a current and a voltage of each of the battery cells (10, 10a, 10b); and
a processor (240) configured to count a number of abnormal occurrences on the basis of the current and the voltage measured by the sensor (230) to detect a contact failure of the battery cells (10, 10a, 10b) due to a short circuit or open circuit of the connecting part (220).

2. The battery contact failure detecting device (200) of claim 1, wherein the processor (240) is configured to count the number of abnormal occurrences on the basis of the current measured by the sensor (230) and a voltage difference between the battery cells (10, 10a, 10b).

3. The battery contact failure detecting device (200) of claim 1, wherein, under a first condition in which the current measured by the sensor (230) is greater than or equal to a threshold current, when a second condition that a voltage difference between the battery cells (10, 10a, 10b) is greater than or equal to a preset reference value is satisfied, the processor (240) is configured to determine that an abnormality occurs and count the number of abnormal occurrences.

4. The battery contact failure detecting device (200) of claim 3, wherein, when the first condition and the second condition are satisfied for a reference period of time, the processor (240) is configured to count the number of abnormal occurrences.

5. The battery contact failure detecting device (200) of claim 3 or 4, wherein the processor (240) is configured to count the number of abnormal occurrences in units of times that are each preset to be smaller than a time for detecting an over voltage or an under voltage.

6. The battery contact failure detecting device (200) of any one of the preceding claims, wherein the processor (240) is configured to restrict use of the battery based on whether a contact failure of the battery cells (10, 10a, 10b) is detected.

7. The battery contact failure detecting device (200) of claim 6, wherein, when the number of abnormal occurrences greater than or equal to a first set number is counted in succession, the processor (240) is configured to restrict use of the battery.

8. The battery contact failure detecting device (200) of claim 6 or 7, wherein, when an accumulated number of abnormal occurrences greater than or equal to a second set number is counted, the processor (240) is configured to restrict use of the battery.

9. A battery contact failure detecting method comprising:
measuring, by a sensor (230), a current and a voltage of each of a plurality of battery cells (10, 10a, 10b);
counting, by a processor (240), a number of abnormal occurrences on the basis of the current and the voltage measured by the sensor (230); and
detecting, by the processor (240), a contact failure of the battery cells (10, 10a, 10b) due to a short circuit or an open circuit of a connecting part (220) connecting the battery cells (10, 10a, 10b) to each other on the basis of the counted number of abnormal occurrences.

10. The battery contact failure detecting method of claim 9, wherein the counting the number of abnormal occurrences comprises counting the number of abnormal occurrences on the basis of the current measured by the sensor (230) and a voltage difference between the battery cells (10, 10a, 10b).

11. The battery contact failure detecting method of claim 9, wherein the counting the number of abnormal occurrences comprises:
determining whether a first condition that the current measured by the sensor (230) is greater than or equal to a threshold current is satisfied;
determining whether a second condition that a voltage difference between the battery cells (10, 10a, 10b) is greater than or equal to a preset reference value is satisfied;
determining that an abnormality occurs when the first condition and the second condition are satisfied; and
counting the number of abnormal occurrences.

12. The battery contact failure detecting method of claim 11, wherein the counting the number of abnormal occurrences comprises counting the number of abnormal occurrences when the first condition and the second condition are satisfied for a reference period of time.

13. The battery contact failure detecting method of claim 11 or 12, wherein the counting the number of abnormal occurrences comprises counting the number of abnormal occurrences in units of time that are each preset to be smaller than a time for detecting an over voltage or an under voltage.

14. The battery contact failure detecting method of any one of claims 9 to 13, further comprising restricting, by the processor (240), use of the battery based on whether the contact failure of the battery cells (10, 10a, 10b) is detected.

15. The battery contact failure detecting method of claim 14, wherein the restricting the use of the battery comprises restricting the use of the battery when the number of abnormal occurrences greater than or equal to a first set number is counted in succession and/or an accumulated number of abnormal occurrences greater than or equal to a second set number is counted.
